(19) **Europäisches Patentamt**
**European Patent Office**
**Office européen des brevets**

(11) **EP 3 208 858 B1**

(12) **EUROPEAN PATENT SPECIFICATION**

(45) Date of publication and mention
of the grant of the patent:
**02.10.2024 Bulletin 2024/40**

(21) Application number: **15850500.8**

(22) Date of filing: **14.10.2015**

(51) International Patent Classification (IPC):
*H01G 9/20* $^{(2006.01)}$   *H10K 30/15* $^{(2023.01)}$
*H10K 30/88* $^{(2023.01)}$   *H10K 85/10* $^{(2023.01)}$
*H10K 85/50* $^{(2023.01)}$

(52) Cooperative Patent Classification (CPC):
**H01G 9/2077; H10K 30/88; H10K 85/141;**
**H10K 85/50;** H10K 30/50; Y02E 10/542;
Y02E 10/549

(86) International application number:
**PCT/JP2015/079005**

(87) International publication number:
**WO 2016/060156 (21.04.2016 Gazette 2016/16)**

(54) **SOLAR CELL**

SOLARZELLE

CELLULE SOLAIRE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **14.10.2014 JP 2014210187**

(43) Date of publication of application:
**23.08.2017 Bulletin 2017/34**

(73) Proprietor: **Sekisui Chemical Co., Ltd.**
**Osaka-shi, Osaka 530-0047 (JP)**

(72) Inventors:
• **HAYAKAWA Akinobu**
**Mishima-gun**
**Osaka 618-0021 (JP)**
• **ASANO Motohiko**
**Mishima-gun**
**Osaka 618-0021 (JP)**
• **UNO Tomohito**
**Mishima-gun**
**Osaka 618-0021 (JP)**

• **HORIKI Mayumi**
**Mishima-gun**
**Osaka 618-0021 (JP)**
• **FUKUMOTO Yuuichirou**
**Mishima-gun**
**Osaka 618-0021 (JP)**
• **KUREBAYASHI Tetsuya**
**Mishima-gun**
**Osaka 618-0021 (JP)**
• **OHARA Shunji**
**Mishima-gun**
**Osaka 618-0021 (JP)**

(74) Representative: **Cabinet Beau de Loménie**
**158, rue de l'Université**
**75340 Paris Cedex 07 (FR)**

(56) References cited:
**EP-A1- 2 498 330       EP-A1- 3 276 694**
**EP-A2- 2 897 178       WO-A1-2009/125685**
**WO-A1-2011/062932       WO-A1-2013/171520**
**WO-A2-2014/042449       WO-A2-2014/042449**
**JP-A- 2014 056 940       US-A- 4 275 180**

**Description**

TECHNICAL FIELD

The present invention relates to a solar cell that is excellent in photoelectric conversion efficiency, suffers little degradation during encapsulation (initial degradation), and has high-temperature durability.

BACKGROUND ART

Photoelectric conversion elements equipped with a laminate having an N-type semiconductor layer and a P-type semiconductor layer disposed between opposing electrodes have been conventionally developed. Such photoelectric conversion elements generate photocarriers by photoexcitation so that electrons and holes move through the N-type semiconductor and the P-type semiconductor, respectively, to create an electric field.

Most photoelectric conversion elements currently in practical use are inorganic solar cells which are produced using inorganic semiconductors made of silicon or the like. The inorganic solar cells, however, are utilized only in a limited range because their production is costly and upsizing thereof is difficult. Therefore, organic solar cells produced using organic semiconductors instead of inorganic semiconductors have received attention.

In organic solar cells, fullerene is used in most cases. Fullerene is known to function mainly as an N-type semiconductor. For example, Patent Literature 1 discloses a semiconductor heterojunction film formed using an organic compound serving as a P-type semiconductor, and fullerenes. Fullerene, however, is known to be responsible for degradation of organic solar cells produced using the fullerene (see e.g., Non-Patent Literature 1). Thus, there is a demand for selecting a material with higher durability than fullerene.

In the organic solar cells, a laminate having an N-type semiconductor layer and a P-type semiconductor layer disposed between opposing electrodes is generally encapsulated using an encapsulation resin such as a sealing material (see e.g., Non-Patent Literature 2). However, the problem of the organic solar cells encapsulated using an encapsulation resin such as a sealing material is that, depending on the type of a semiconductor material, the semiconductor material is degraded during encapsulation, resulting in reduced photoelectric conversion efficiency (initial degradation).

CITATION LIST

- Patent Literature

Patent Literature 1: JP 2006-344794 A

- Non-Patent Literature

Non-Patent Literature 1: Reese et al., Adv.Funct.Mater., 20, 3476-3483 (2010)
Non-Patent Literature 2: Proc.of SPIE Vol.7416 74160K-1

An optoelectronic device of WO 2013/171520 A1 comprises a porous material, which porous material comprises a semiconductor comprising a perovskite, the porous material being perovskite.

WO 2014/042449 A2 shows a solar cell including a first electrode, a composite layer disposed on the first electrode and containing a light absorber, a light-absorbing structure disposed on the composite layer and consisting of a light absorber, a hole conductive layer disposed on the light-absorbing structure, and a second electrode disposed on the hole conductive layer.

A wet solar cell of EP 2 498 330 A1 includes a substrate having a light-receiving surface, a seal portion disposed opposite to the substrate, a first electrode formed on the top surface of a side of the substrate that is opposite to the seal portion, an insulating frame disposed between the first electrode and the seal portion to surround four sides so that a space is formed inside the insulating frame, a photoelectric conversion portion formed on a top surface of the first electrode, and a second electrode formed to extend toward the seal portion from a top surface of another first electrode adjacent to the first electrode and having a top surface partially located opposite to the seal portion.

An assembly including a pressure-sensitive adhesive layer at least 0.25 mm in thickness disposed on a barrier assembly is shown in WO 2011/062932 A1, wherein the barrier assembly comprises a polymeric film substrate and a barrier film, the pressure-sensitive adhesive including a polyisobutylene.

SUMMARY OF INVENTION

- Technical Problem

An object of the present invention is to provide a solar cell that is excellent in photoelectric conversion efficiency, suffers little degradation during encapsulation (initial degradation), and has high-temperature durability.

- Solution to problem

The present invention is defined in the claim.

Use of a particular organic-inorganic perovskite compound for a photoelectric conversion layer in a laminate having an electrode, a counter electrode, and a photoelectric conversion layer disposed between the electrode and the counter electrode can be expected to improve the photoelectric conversion efficiency of the solar cell.

However, encapsulation of a laminate including a photoelectric conversion layer containing the organic-inorganic perovskite compound with an encapsulation resin layer was found to reduce the photoelectric conversion efficiency during the encapsulation (initial degradation). In addition, it was found that, when the encapsulated solar cell is left at high temperatures, the photoelectric conversion efficiency is also lowered (high-temperature degradation).

Degradation that occurs when a laminate including a photoelectric conversion layer using an organic-inorganic perovskite compound is encapsulated with an encapsulation resin layer arises because, during encapsulation or at high temperatures, an organic component in the organic-inorganic perovskite compound is dissolved into the encapsulation resin layer so that the organic-inorganic perovskite compound is degraded.

Adjustment of the solubility parameter (SP value) of the resin included in the encapsulation resin layer within a specific range can prevent an organic component in the organic-inorganic perovskite compound from being eluted during encapsulation or at high temperatures.

The term "layer" as used herein means not only a layer having a clear boundary, but even a layer having a concentration gradient in which contained elements are gradually changed. The elemental analysis of the layer can be conducted, for example, by FE-TEM/EDS analysis and measurement of the cross section of the solar cell to confirm the element distribution of a particular element. The term "layer" as used herein means not only a flat thin film-shaped layer, but also a layer capable of forming an intricate structure together with other layer(s).

The materials of the electrode and the counter electrode are not particularly limited, and conventionally known materials may be used. The counter electrode is often a patterned electrode.

Examples of the materials of the electrode and the counter electrode include fluorine-doped tin oxide (FTO), sodium, sodium-potassium alloys, lithium, magnesium, aluminum, magnesium-silver mixtures, magnesium-indium mixtures, aluminum-lithium alloys, $Al/Al_2O_3$ mixtures, Al/LiF mixtures, metals such as gold, CuI, conductive transparent materials such as indium tin oxide (ITO), $SnO_2$, aluminum zinc oxide (AZO), indium zinc oxide (IZO) and gallium zinc oxide (GZO), and conductive transparent polymers. These materials may be used alone or may be used in combination of two or more thereof.

The electrode and the counter electrode may each be either a cathode or an anode.

The photoelectric conversion layer includes an organic-inorganic perovskite compound represented by the formula $R-M-X_3$ wherein R represents an organic molecule, M represents a metal atom, and X represents a halogen atom or a chalcogen atom.

Use of the organic-inorganic perovskite compound in the photoelectric conversion layer can improve the photoelectric conversion efficiency of the solar cell.

The R is an organic molecule and is preferably represented by $C_lN_mH_n$ (1, m and n each represent a positive integer).

Specific examples of the R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, formamidine, imidazole, azole, pyrrole, aziridine, azirine, azetidine, azete, azole, imidazoline, carbazole and their ions (e.g., methylammonium ($CH_3NH_3$)), and phenethylammonium. Among them, methylamine, ethylamine, propylamine, butylamine, pentylamine, hexylamine, formamidine, guanidine and their ions, and phenethylammonium are preferred, and methylamine, ethylamine, propylamine, formamidine, guanidine and their ions are more preferred.

The M is a metal atom. Examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. These metal atoms may be used alone or may be used in combination of two or more thereof.

The X is a halogen atom or a chalcogen atom.
Examples thereof include chlorine, bromine, iodine, sulfur, and selenium. These halogen atoms or chalcogen atoms may be used alone or may be used in combination of two or more thereof. Among them, a halogen atom is preferred because the organic-inorganic perovskite compound containing halogen in the structure is soluble in an organic solvent and is usable in an inexpensive printing method or the like. In addition, iodine is more preferred because the organic-inorganic perovskite compound has a narrow energy band gap.

The organic-inorganic perovskite compound preferably has a cubic structure where the metal atom M is placed at the body center, the organic molecule R is placed at each vertex, and the halogen atom or chalcogen atom X is placed at each face center.

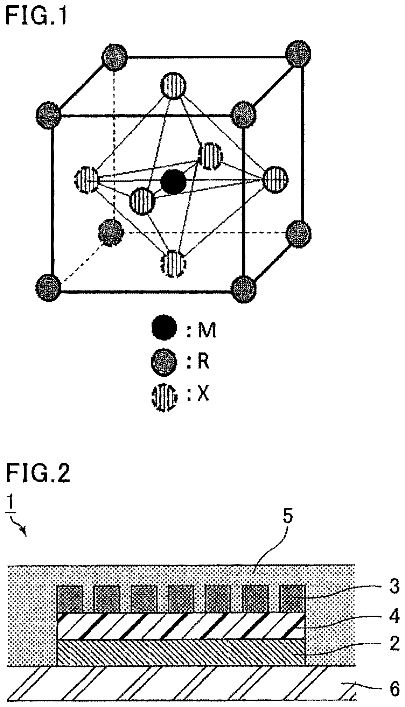

Fig. 1 is a schematic view illustrating an exemplary crystal structure of the organic-inorganic perovskite compound having a cubic structure where the metal atom M is placed at the body center, the organic molecule R is placed at each vertex, and the halogen atom or chalcogen atom X is placed at each face center. Although details are not clear, it is presumed that the direction of an octahedron in the crystal lattice can be easily changed owing to the structure; thus the mobility of electrons in the organic-inorganic perovskite compound is enhanced, improving the photoelectric conversion efficiency of the solar cell.

The organic-inorganic perovskite compound is preferably a crystalline semiconductor. The crystalline semiconductor means a semiconductor whose scattering peak can be detected by the measurement of X-ray scattering intensity distribution. When the organic-inorganic perovskite compound is a crystalline semiconductor, the mobility of electrons in the organic-inorganic perovskite compound is enhanced, improving the photoelectric conversion efficiency of the solar cell.

The degree of crystallinity can also be evaluated as an index of crystallization. The degree of crystallinity can be determined by separating a crystalline substance-derived scattering peak from an amorphous portion-derived halo, which are detected by X-ray scattering intensity distribution measurement, by fitting, determining their respective intensity integrals, and calculating the ratio of the crystalline portion to the whole.

The lower limit of the degree of crystallinity of the organic-inorganic perovskite compound is preferably 30%. When the degree of crystallinity is 30% or more, the mobility of electrons in the organic-inorganic perovskite compound is enhanced, improving the photoelectric conversion efficiency of the solar cell. The lower limit of the degree of crystallinity is more preferably 50%, further preferably 70%.

Examples of the method for increasing the degree of crystallinity of the organic-inorganic perovskite compound include heat annealing, irradiation with light having strong intensity, such as laser, and plasma irradiation.

The photoelectric conversion layer may further include an organic semiconductor or an inorganic semiconductor, in addition to the organic-inorganic perovskite compound, without impairing the effects of the present invention. In this context, the organic semiconductor or the inorganic semiconductor may play a role as an electron transport layer or a hole transport layer mentioned later.

Examples of the organic semiconductor include compounds having a thiophene skeleton, such as poly(3-alkylthiophene). Examples thereof also include conductive polymers having a poly-p-phenylenevinylene skeleton, a polyvinylcarbazole skeleton, a polyaniline skeleton, a polyacetylene skeleton or the like. Examples thereof further include: compounds having a phthalocyanine skeleton, a naphthalocyanine skeleton, a pentacene skeleton, a porphyrin skeleton such as a benzoporphyrin skeleton, a spirobifluorene skeleton or the like; and carbon-containing materials such as carbon nanotube, graphene, and fullerene, which may be surface-modified.

Examples of the inorganic semiconductor include titanium oxide, zinc oxide, indium oxide, tin oxide, gallium oxide, tin sulfide, indium sulfide, zinc sulfide, $CuSCN$, $Cu_2O$, $CuI$, $MoO_3$, $V_2O_5$, $WO_3$, $MoS_2$, $MoSe_2$ and $Cu_2S$.

The photoelectric conversion layer including the organic semiconductor or the inorganic semiconductor may be a laminated structure where a thin film-shaped organic semiconductor or inorganic semiconductor part and a thin film-shaped organic-inorganic perovskite compound part are laminated, or may be a composite structure where an organic semiconductor or inorganic semiconductor part and an organic-inorganic perovskite compound part are combined. The laminated structure is preferred from the viewpoint that the production process is simple. The composite structure is preferred from the viewpoint that the charge separation efficiency of the organic semiconductor or the inorganic semiconductor can be improved.

The lower limit of the thickness of the thin film-shaped organic-inorganic perovskite compound part is preferably 5 nm, and the upper limit thereof is preferably 5,000 nm. When the thickness is 5 nm or larger, light can be sufficiently absorbed, enhancing the photoelectric conversion efficiency. When the thickness is 5,000 nm or smaller, presence of a region in which charge separation cannot be achieved can be avoided, leading to higher photoelectric conversion efficiency. The lower limit of the thickness is more preferably 10 nm, and the upper limit thereof is more preferably 1,000 nm. The lower limit of the thickness is further preferably 20 nm, and the upper limit thereof is further preferably 500 nm.

When the photoelectric conversion layer is a composite structure where an organic semiconductor or inorganic semiconductor part and an organic-inorganic perovskite compound part are combined, the lower limit of the thickness of the composite structure is preferably 30 nm, and the upper limit thereof is preferably 3,000 nm. When the thickness is 30 nm or larger, light can be sufficiently absorbed, enhancing the photoelectric conversion efficiency. When the thickness is 3,000 nm or smaller, charge easily arrives at the electrode, enhancing the photoelectric conversion efficiency.

The lower limit of the thickness is more preferably 40 nm, and the upper limit thereof is more preferably 2,000 nm. The lower limit of the thickness is further preferably 50 nm, and the upper limit thereof is further preferably 1,000 nm.

In the laminate, an electron transport layer may be disposed between the electrode and the photoelectric conversion layer.

Examples of the material for the electron transport layer include, but are not particularly limited to, N-type conductive polymers, N-type low-molecular organic semiconductors, N-type metal oxides, N-type metal sulfides, alkali metal halides, alkali metals, and surfactants. Specific examples thereof include cyano group-containing polyphenylenevinylene, boron-containing polymers, bathocuproine, bathophenanthroline, hydroxyquinolinatoaluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The electron transport layer may consist only of a thin film-shaped electron transport layer and preferably includes a porous electron transport layer. Particularly, when the photoelectric conversion layer is a composite structure where an organic semiconductor or inorganic semiconductor part and an organic-inorganic perovskite compound part are combined, a film of the composite structure is preferably formed on a porous electron transport layer because a more complicated composite structure (more intricate structure) is obtained, enhancing the photoelectric conversion efficiency.

The lower limit of the thickness of the electron transport layer is preferably 1 nm, and the upper limit thereof is preferably 2,000 nm. When the thickness is 1 nm or larger, holes can be sufficiently blocked. When the thickness is 2,000 nm or smaller, the layer is less likely to be the resistance to the electron transport, enhancing the photoelectric conversion efficiency. The lower limit of the thickness of the electron transport layer is more preferably 3 nm, and the upper limit thereof is more preferably 1,000 nm. The lower limit of the thickness is further preferably 5 nm, and the upper limit thereof is further preferably 500 nm.

In the laminate, a hole transport layer may be disposed between the counter electrode and the photoelectric conversion layer.

Examples of the material of the hole transport layer include, but are not particularly limited to, P-type conductive polymers, P-type low-molecular organic semiconductors, P-type metal oxides, P-type metal sulfides, and surfactants. Specific examples thereof include polystyrenesulfonic acid adducts of polyethylenedioxythiophene, carboxyl group-containing polythiophene, phthalocyanine, porphyrin, molybdenum oxide, vanadium oxide, tungsten oxide, nickel oxide, copper oxide, tin oxide, molybdenum sulfide, tungsten sulfide, copper sulfide, tin sulfide, fluoro group-containing phosphonic acid, carbonyl group-containing phosphonic acid, copper compounds such as CuSCN and CuI, and carbon-containing materials such as carbon nanotube and graphene.

The lower limit of the thickness of the hole transport layer is preferably 1 nm, and the upper limit thereof is preferably 2,000 nm. When the thickness is 1 nm or larger, electrons can be sufficiently blocked. When the thickness is 2,000 nm or smaller, the layer is less likely to be the resistance to the hole transport, enhancing the photoelectric conversion efficiency. The lower limit of the thickness is more preferably 3 nm, and the upper limit thereof is more preferably 1,000 nm. The lower limit of the thickness is further preferably 5 nm, and the upper limit thereof is further preferably 500 nm.

The laminate may further have a substrate or the like. Examples of the substrate include, but are not particularly limited to, transparent glass substrates such as soda lime glass and alkali-free glass substrates, ceramic substrates and transparent plastic substrates.

In the solar cell of the present invention, the laminate is encapsulated with an encapsulation resin layer covering the counter electrode.

Encapsulation of the laminate with the encapsulation resin layer covering the counter electrode can improve the durability of the solar cell. This is probably because encapsulation with the encapsulation resin layer can suppress moisture penetration into the inside. In this context, the encapsulation resin layer preferably covers the laminate entirely so as to close the end portions thereof. This can reliably prevent moisture penetration into the inside.

The encapsulation resin layer consists of a resin having a solubility parameter (SP value) of 10 or less.

When the organic-inorganic perovskite compound is used in the photoelectric conversion layer, during encapsulation or at high temperatures, an organic component in the organic-inorganic perovskite compound is dissolved into the encapsulation resin layer so that the organic-inorganic perovskite compound is degraded (initial degradation, high-temperature degradation). By contrast, in the solar cell of the present invention, adjustment of the solubility parameter (SP value) of the resin included in the encapsulation resin layer (hereafter, also simply referred to as a "encapsulation resin") within the above range can prevent elution of an organic component in the organic-inorganic perovskite compound during encapsulation or at high temperatures and thus prevent degradation of the photoelectric conversion layer, even when the organic-inorganic perovskite compound is used in the photoelectric conversion layer.

When the encapsulation resin has a solubility parameter (SP value) of 10 or less, elution of an organic component in the organic-inorganic perovskite compound during encapsulation or at high temperatures is inhibited, thereby suppressing degradation of the photoelectric conversion layer. For further enhancing the high-temperature durability of the solar cell, the upper limit of the solubility parameter (SP value) of the encapsulation resin is preferably 9.5, more preferably 9.

The solubility parameter (SP value) of the encapsulation resin is preferably 6 or more. When the solubility parameter (SP value) is 6 or more, more resins are selectable and such a resin is easier to mold. The lower limit of the solubility parameter (SP value) of the encapsulation resin is more preferably 6.5, still more preferably 7, particularly preferably 7.5.

The SP value is called the solubility parameter and is an index capable of showing ease of dissolution. The SP value herein can be determined by a method proposed by Fedors (R.F. Fedors, Polym. Eng. Sci., 14 (2), 147-154 (1974)), and calculated according to the equation (1) given below based on the evaporation energy ($\Delta$ecoh) (cal/mol) and molar volume ($\Delta$v) (cm$^3$/mol) of each atomic group in repeating units. In the equation (1), $\delta$ represents the SP value (cal/mol)$^{1/2}$.

$$\delta = \sqrt{\frac{\sum \Delta ecoh}{\sum \Delta v}} \qquad (1)$$

Values described in J. Brandrup et al., "Polymer Handbook, Fourth Edition", volume 2 can be used as $\Delta$ecoh and $\Delta$v.

In the case of Tg $\geq$ 25°C, 2n (n represents the number of main chain atoms) at n $\geq$ 3 or 4n at n < 3 is added to $\Delta$v for the calculation.

The SP value of the copolymer can be calculated according to the equation (2) given below using the calculated SP value of each repeating unit alone in the copolymer, and the volume fraction thereof. In the equation (2), $\delta$cop represents the SP value of the copolymer, $\phi$1 and $\phi$2 represent the respective volume fractions of repeating units 1 and 2, and $\delta$1. and $\delta$2 represent the respective SP values of repeating units 1 and 2 each calculated alone.

$$\delta cop^2 = \phi_1 \delta_1^2 + \phi_2 \delta_2^2 \qquad (2)$$

The encapsulation resin is not limited, and may be, for example, a silicone resin (SP value: about 7.5), polyolefin resin (SP value: about 8), butyl rubber (SP value: about 8), Teflon ($^®$) resin (SP value: about 7.5), polyisobutylene (SP value: about 7.5), or acrylic resin (SP value: about 9.5). In particular, the encapsulation resin is preferably a silicone resin, polyolefin resin, butyl rubber, or polyisobutylene because they each have a SP value at a favorable position.

Epoxy resins that are commonly used as an encapsulation resin for solar cells have a solubility parameter (SP value) of about 10.5, which does not fall within the above range of the solubility parameter (SP value).

The SP value of the encapsulation resin is adjusted within a favorable range by blending two materials with different SP values within an appropriate range, by selecting a monomer having a skeleton appropriate for a monomer used in polymerization, or by addition-reacting a reactive compound having an appropriate skeleton.

The encapsulation resin may be a resin obtained by forming a compound having a reactive functional group into a film and crosslinking the reactive functional group using a crosslinking agent. In this case, adjustment of the number of the reactive functional groups can suppress the degradation (initial degradation) of the solar cell during encapsulation due to curing shrinkage accompanying the crosslinking reaction, thereby improving sputtering resistance.

Examples of the reactive functional group include epoxy, hydroxy, carboxyl, alkenyl, and isocyanate groups.

The lower limit of the thickness of the encapsulation resin is preferably 100 nm, and the upper limit thereof is preferably 100,000 nm. The lower limit of the thickness is more preferably 500 nm, and the upper limit thereof is more preferably 50,000 nm. The lower limit of the thickness is further preferably 1,000 nm, and the upper limit thereof is further preferably 20,000 nm.

The solar cell of the present invention further includes an inorganic layer on the encapsulation resin layer. Having a high water vapor barrier property, the inorganic layer can further suppress moisture penetration into the inside and can therefore further improve the durability of the solar cell.

The metal oxide, metal nitride, or metal oxynitride has a water vapor barrier property and includes an oxide, nitride, or oxynitride of Si, Al, Zn, or Sn, and an oxide, nitride, or oxynitride of Zn or Sn is preferred. An oxide, nitride, or oxynitride of metal elements including both of the metal elements Zn and Sn is further preferred because a particularly high water vapor barrier property and plasticity can be imparted to the inorganic layer.

Among others, the metal oxide, metal nitride, or metal oxynitride is particularly preferably a metal oxide represented by the formula $Zn_aSn_bO_c$. In this formula, a, b and c each represent a positive integer.

Use of the metal oxide represented by the formula $Zn_aSn_bO_c$ in the inorganic layer can impart moderate flexibility to the inorganic layer because the metal oxide contains a tin (Sn) atom, so that stress is decreased even when the thickness of the inorganic layer is increased. Therefore, peeling of the inorganic layer, electrode, semiconductor layer, and the like can be suppressed. This can enhance the water vapor barrier property of the inorganic layer and further improve the durability of the solar cell. Meanwhile, the inorganic layer can exert a particularly high barrier property because the metal oxide contains a zinc (Zn) atom.

In the metal oxide represented by the formula $Zn_aSn_bO_c$, the ratio Xs (% by weight) of Sn to the total sum of Zn and Sn preferably satisfies 70 > Xs > 0. Also, value Y represented by Y = c / (a + 2b) preferably satisfies 1.5 > Y > 0.5.

The element ratios of zinc (Zn), tin (Sn), and oxygen (O) contained in the metal oxide represented by the formula $Zn_aSn_bO_c$ in the inorganic layer can be measured using an X-ray photoemission spectroscopy (XPS) surface analyzer (e.g., ESCALAB-200R available from VG Scientific).

Preferably, the inorganic layer containing the metal oxide represented by the formula $Zn_aSn_bO_c$ further contains silicon (Si) and/or aluminum (Al).

The addition of silicon (Si) and/or aluminum (Al) to the inorganic layer can enhance the transparency of the inorganic layer and improve the photoelectric conversion efficiency of the solar cell.

The lower limit of the thickness of the inorganic layer is preferably 30 nm, and the upper limit thereof is preferably 3,000 nm. When the thickness is 30 nm or larger, the inorganic layer can have an adequate water vapor barrier property, improving the durability of the solar cell. When the thickness is 3,000 nm or smaller, only small stress is generated even when the thickness of the inorganic layer is increased. Therefore, peeling of the inorganic layer, electrode, semiconductor layer, and the like can be suppressed. The lower limit of the thickness is more preferably 50 nm, and the upper limit thereof is more preferably 1,000 nm. The lower limit of the thickness is further preferably 100 nm, and the upper limit thereof is further preferably 500 nm.

The thickness of the inorganic layer can be measured using an optical interference-type film thickness measurement apparatus (e.g., FE-3000 available from Otsuka Electronics Co., Ltd.).

In the solar cell of the present invention, the encapsulation resin may be further covered with, for example, an additional material such as a glass sheet, resin film, inorganic material-coated resin film, or metal (e.g., aluminum) foil. Specifically, the solar cell of the present invention may be configured such that encapsulation, filling, or bonding between the laminate and the additional material is attained by the encapsulation resin. This can sufficiently block water vapor even when a pinhole is present in the encapsulation resin, and can further improve the high-temperature and high-humidity durability of the solar cell. Among them, an inorganic material-coated resin film is more preferably disposed thereon.

Fig. 2 is a cross-sectional view schematically illustrating an exemplary solar cell of the present invention.

In a solar cell 1 shown in Fig. 2, a laminate having, on a substrate 6, an electrode 2, a counter electrode 3, and a photoelectric conversion layer 4 disposed between the electrode 2 and the counter electrode 3 is encapsulated with an encapsulation resin layer 5 that covers the counter electrode 3. In this context, the end portions of the encapsulation resin layer 5 are closed by intimate contact with the substrate 6. In the solar cell 1 shown in Fig. 2, the counter electrode 3 is a patterned electrode. An inorganic layer (not shown) may be disposed between the laminate and the encapsulation resin 5 or on the encapsulation resin 5.

Examples of the method for producing the solar cell of the present invention include, but are not particularly limited to, a method which involves forming the electrode, the photoelectric conversion layer, and the counter electrode in this order on the substrate to prepare a laminate, then encapsulating the laminate with the encapsulation resin, and further covering the encapsulation resin with an inorganic layer.

Examples of the method for forming the photoelectric conversion layer include, but are not particularly limited to, a vapor deposition method, a sputtering method, a chemical vapor deposition (CVD) method, an electrochemical deposition method, and a printing method. Among them, employment of a printing method allows simple formation of a large-area solar cell that can exhibit high photoelectric conversion efficiency. Examples of the printing method include a spin coating method and a casting method. Examples of the method using the printing method include a roll-to-roll method.

Examples of the method for encapsulating the laminate with the encapsulation resin include a method which involves applying an encapsulation resin solution containing the encapsulation resin dissolved in an organic solvent to the laminate, a method which involves applying a compound having a reactive functional group to be the encapsulation resin to the laminate, followed by cross-linking or polymerization of the compound having a reactive functional group using heat, UV, or the like, and a method which involves melting the encapsulation resin under heat, followed by cooling.

The method for covering the encapsulation resin with the inorganic layer is preferably a vacuum deposition method, a sputtering method, a chemical vapor deposition (CVD) method, or an ion plating method. Among them, a sputtering method is preferred for forming a dense layer. The sputtering method is more preferably a DC magnetron sputtering method.

In the sputtering method, the inorganic layer can be formed by depositing raw materials including a metal target and oxygen gas or nitrogen gas on the encapsulation resin for film formation.

- Advantageous Effects of Invention

The present invention can provide a solar cell that is excellent in photoelectric conversion efficiency, suffers little degradation during encapsulation (initial degradation), and has high-temperature durability.

BRIEF DESCRIPTION OF DRAWINGS

Fig. 1 is a schematic view illustrating an exemplary crystal structure of the organic-inorganic perovskite compound.
Fig. 2 is a cross-sectional view schematically illustrating an exemplary solar cell of the present invention.

DESCRIPTION OF EMBODIMENTS

Hereinafter, the present invention will be described in more detail with reference to Example 14. The present invention is defined in the claims, and Examples 1 to 13 and 15 to 17 are reference examples not according to the claimed invention.

(Example 1)

(Preparation of a laminate)

A FTO film having a thickness of 1,000 nm was formed as an electrode on a glass substrate, ultrasonically washed with pure water, acetone, and methanol each for ten minutes in the stated order, and then dried.
An ethanol solution of titanium isopropoxide adjusted to 2% was applied onto the surface of the FTO film by the spin coating method and then fired at 400°C for 10 minutes to form a thin film-shaped electron transport layer having a thickness of 20 nm. A titanium oxide paste containing polyisobutyl methacrylate as an organic binder and titanium oxide (mixture of powders having average particle sizes of 10 nm and 30 nm) was further applied onto the thin film-shaped electron transport layer by the spin coating method and then fired at 500°C for 10 minutes to form a porous electron transport layer having a thickness of 500 nm.
Subsequently, $CH_3NH_3I$ and $PbI_2$ were dissolved at a molar ratio of 1:1 in N,N-dimethylformamide (DMF) as a solvent to prepare a solution for organic-inorganic perovskite compound formation having a total concentration of $CH_3NH_3I$ and $PbI_2$ of 20% by weight. This solution was applied onto the electron transport layer by the spin coating method to form a photoelectric conversion layer.
Further, 68 mM spiro-OMeTAD (having a spirobifluorene skeleton), 55 mM tert-butylpyridine and 9 mM lithium bis(trifluoromethylsufonyl)imide salt were dissolved in 25 μL of chlorobenzene to prepare a solution. This solution was applied to a thickness of 300 nm onto the photoelectric conversion layer by the spin coating method to form a hole transport layer.
A gold film having a thickness of 100 nm was formed as a counter electrode on the hole transport layer by vacuum deposition to obtain a laminate.

(Sealing of a laminate)

The obtained laminate was further laminated with aluminum foil on which a polyisobutylene resin (OPPANOL 100 available from BASF SE, SP value of 7.2) was stacked to a thickness of 10 um at 100°C. A solar cell was thus prepared.

(Examples 2 to 5)

A solar cell was obtained in the same manner as in Example 1, except that in preparation of the laminate, the components contained in the solution for organic-inorganic perovskite compound formation was changed to form a photoelectric conversion layer (organic-inorganic perovskite compound) shown in Table 1.
In Example 2, $CH_3NH_3Br$, $CH_3NH_3I$, $PbBr_2$, and $PbI_2$ were dissolved at a molar ratio of 1:2:1:2 in N,N-dimethylformamide (DMF) as a solvent. In Example 3, $CH_3NH_3I$ and $PbCl_2$ were dissolved at a molar ratio of 3:1 in N,N-dimethylformamide (DMF) as a solvent. In Example 4, $CH_3NH_3Br$ and $PbBr_2$ were dissolved at a molar ratio of 1:1 in N,N-dimethylformamide (DMF) as a solvent. In Example 5, $CH_3(NH_3)_2I$ and $PbI_2$ were dissolved at a molar ratio of 1:1 in N,N-dimethylformamide (DMF) as a solvent.

(Examples 6 to 10)

A solar cell was obtained in the same manner as in Example 1, except that an encapsulation resin (SP value) as specified in Table 1 was used.

In Example 6, a silicone resin was used as an encapsulation resin. The silicon resin was cured by heating at 120°C after lamination. In Example 7, a polyethylene resin (available from Wako Pure Chemical Industries, Ltd., SP value of 8.6) was used. In Example 8, a polybutadiene resin (available from Wako Pure Chemical Industries, Ltd., SP value of 8.4) was used. In Example 9, a mixture of 4 mol% of a peroxide (PERCUMYL D, available from NOF Corporation) as a curing agent and ethyl methacrylate (available from Kyoeisha Chemical Co., Ltd., LIGHT ESTER E, SP value of 9.4) was used. The mixture was cured by heating at 120°C for one hour after lamination. In Example 10, polymethyl methacrylate (PMMA) (available from Wako Pure Chemical Industries, Ltd., SP value of 9.6) was used.

The silicone resin was prepared by polymerization as described below.

A 1000-mL separable flask equipped with a thermometer, a dripping device, and a stirrer was charged with 164.1 g of dimethyldimethoxysilane, 6.6 g of methyl vinyl dimethoxysilane, and 4.7 g of 1,3-divinyl-1,1,3,3-tetramethyldisiloxane, and they were stirred at 50°C. To the mixture was slowly dripped a solution prepared by dissolving 2.2 g of potassium hydroxide in 35.1 g of water. After the dripping, the mixture was stirred at 50°C for six hours to be reacted. A reaction solution was thus obtained. Next, volatile components were removed by depressurization, and 2.4 g of acetic acid was added to the reaction solution. The resulting reaction solution was heated under reduced pressure. Then, potassium acetate was filtered off, thereby preparing a polymer A.

Separately, a 1000-mL separable flask equipped with a thermometer, a dripping device, and a stirrer was charged with 80.6 g of dimethyldimethoxysilane and 45 g of 1,1,3,3-tetramethyldisiloxane, and they were stirred at 50°C. To the mixture was dripped slowly a solution prepared by blending 100 g of acetic acid with 27 g of water. After the dripping, the mixture was stirred at 50°C for six hours to be reacted. A reaction solution was thus prepared. Next, volatile components were removed by depressurization, thereby preparing a polymer. The obtained polymer was blended with 150 g of hexane and 150 g of ethyl acetate, and washed with 300 g of ion exchange water ten times. Volatile components therein were removed by depressurization, thereby preparing a polymer B.

An amount of 90 parts by weight of the polymer A, 12 parts by weight of the polymer B, and 0.2% by weight of a hydrosilylation catalyst (platinum-1,3-divinyl-1,1,3,3-tetramethyldisiloxane complex) were mixed to prepare the silicone resin.

(Examples 11 to 13)

A solar cell was prepared in the same manner as in Example 1, except that lamination with aluminum foil on which an encapsulation resin was stacked was performed after formation of an inorganic layer as shown in Table 1.

(Method for forming an inorganic layer)

The obtained laminate was set in a substrate holder of a sputtering device. In addition, a Zn-Sn alloy (Zn:Sn = 95:5 (% by weight)) target was mounted on cathode A of the sputtering device, and a Si target was mounted on cathode B of the sputtering device. A film-forming chamber of the sputtering device was evacuated using a vacuum pump to reduce the pressure to $5.0 \times 10^{-4}$ Pa. Then, sputtering was performed under the sputtering condition A to form a thin film of ZnSnO(Si) as an inorganic layer on the laminate (perovskite solar cell).

<Sputtering condition A>

Argon gas flow rate: 50 sccm, oxygen gas flow rate: 50 sccm Power output: cathode A = 500 W, cathode B = 1500 W

In a case where a $SiO_2$ inorganic layer was formed, a Si target was used as a metal target. In a case where a $SnO_2$ inorganic layer was formed, a Sn target was used as a metal target.

(Example 14)

A solar cell was prepared in the same manner as in Example 1, except that an encapsulation resin (SP value) as specified in Table 1 was used for encapsulation of the laminate.

In Example 14, a solution of a polymer of isobornyl methacrylate (LIGHT ESTER IB-X, available from Kyoeisha Chemical Co., Ltd.) in cyclohexane was applied using a doctor blade to the laminate (perovskite solar cell) to stack an encapsulation resin to a thickness of 10 μm, and the solvent was dried at 100°C for 10 minutes. Then, a thin film of ZnSnO(Si) was formed as an inorganic layer in the same manner as in Example 11.

(Example 15)

A solar cell was prepared in the same manner as in Example 1, except that a solar cell structure as shown in Table 1 was employed in encapsulation of the laminate.

In Example 15, a solution of polyisobutylene in cyclohexane was applied to the laminate (perovskite solar cell) using a doctor blade to stack an encapsulation resin to a thickness of 10 $\mu$m, and the solvent was dried at 100°C for 10 minutes.

(Examples 16 and 17)

A solar cell was prepared in the same manner as in Example 15, except that an encapsulation resin (SP value) as specified in Table 1 was used for encapsulation of the laminate.

In Example 16, a solution of a norbornene resin (TOPAS6013, available from Polyplastics Co., Ltd.) in cyclohexane was applied to the laminate (perovskite solar cell) using a doctor blade to stack an encapsulation resin to a thickness of 10 $\mu$m, and the solvent was dried at 100°C for 10 minutes. In Example 17, a solution of a polymer of isobornyl methacrylate (LIGHT ESTER IB-X, available from Kyoeisha Chemical Co., Ltd.) in cyclohexane was applied to the laminate (perovskite solar cell) using a doctor blade to stack an encapsulation resin to a thickness of 10 $\mu$m, and the solvent was dried at 100°C for 10 minutes.

(Comparative Examples 1 to 3)

A solar cell was prepared in the same manner as in Example 1, except that, as the encapsulation resin for encapsulation of the laminate, polyvinyl alcohol (PVA) (available from Wako Pure Chemical Industries, Ltd., 160-11485, SP value of 14.1), bisphenol A epoxy polymer (available from Mitsubishi Chemical Corporation, EPIKOTE 828, SP value of 10.8), or phenolic resin (available from Dainippon Ink and Chemicals, TD-2090, SP value of 13.5) was used. The bisphenol A epoxy polymer and the phenolic resin were blended with 2-ethyl-4-methylimidazole and hexamethylenetetramine, respectively, each in an amount of 4% by weight as a curing agent, and cured at 120°C for one hour after lamination.

(Comparative Example 4)

A solar cell was obtained in the same manner as in Example 1, except that encapsulation of the laminate was not performed.

<Evaluation>

The solar cells obtained in Examples and Comparative Examples were evaluated as described below.

(1) Degradation during encapsulation (initial degradation)

A power source (236 model, available from Keithley Instruments, Inc.) was connected between the electrodes in the solar cell immediately after encapsulation. The photoelectric conversion efficiency was measured using a solar simulator (available from Yamashita Denso Corp.) having an intensity of 100 mW/cm$^2$ to determine the value of photoelectric conversion efficiency immediately after encapsulation/initial conversion efficiency.

∘ (Good): The value of photoelectric conversion efficiency immediately after encapsulation/initial conversion efficiency was 0.5 or more.
$\times$ (Poor): The value of photoelectric conversion efficiency immediately after encapsulation/initial conversion efficiency was less than 0.5.

(2) High-temperature durability

The solar cell was left for 24 hours under the condition of 100°C or for 72 hours under the condition of 120°C to conduct a durability test at high temperatures. A power source (236 model, available from Keithley Instruments, Inc.) was connected between the electrodes in the solar cell after the durability test. The photoelectric conversion efficiency was measured using a solar simulator (available from Yamashita Denso Corp.) having an intensity of 100 mW/cm$^2$, and the value of photoelectric conversion efficiency after the durability test/photoelectric conversion efficiency immediately after encapsulation was determined.

∘ (Good): The value of photoelectric conversion efficiency after the durability test/photoelectric conversion efficiency immediately after encapsulation was 0.5 or more.

Δ (Average): The value of photoelectric conversion efficiency after the durability test/photoelectric conversion efficiency immediately after encapsulation was 0.2 or more and less than 0.5.

✕ (Poor): The value of photoelectric conversion efficiency after the durability test/photoelectric conversion efficiency immediately after encapsulation was less than 0.2.

(3) High-humidity durability

The solar cell was left for 24 hours under conditions of 30°C and 80% to conduct a durability test at a high humidity. A power source (236 model, available from Keithley Instruments, Inc.) was connected between the electrodes in the solar cell after the durability test. The photoelectric conversion efficiency was measured using a solar simulator (available from Yamashita Denso Corp.) having an intensity of 100 mW/cm$^2$ to determine the value of photoelectric conversion efficiency after the durability test/photoelectric conversion efficiency immediately after encapsulation.

∞∞ (Outstanding): The value of photoelectric conversion efficiency after the durability test/ photoelectric conversion efficiency immediately after encapsulation was 0.95 or more.

∞ (Excellent): The value of photoelectric conversion efficiency after the durability test/ photoelectric conversion efficiency immediately after encapsulation was 0.9 or more and less than 0.95.

∘ (Good): The value of photoelectric conversion efficiency after the durability test/ photoelectric conversion efficiency immediately after encapsulation was 0.5 or more and less than 0.9.

✕ (Poor): The value of photoelectric conversion efficiency after the durability test/ photoelectric conversion efficiency immediately after encapsulation was less than 0.5.

[Table 1]
Examples 1-13 and 15-17 are not according to the claimed invention.

| | Photoelectric conversion layer | Encapsulation resin | SP value of encapsulation resin | Inorganic layer Material | Inorganic layer Thickness (nm) | Solar cell structure | Evaluation Initial degradation | Evaluation High-temperature durability[1] | Evaluation High-temperature durability[2] | Evaluation High-humidity test |
|---|---|---|---|---|---|---|---|---|---|---|
| Example 1 | CH₃NH₃PbI₃ | Polyisobutylene | 7.2 | Not used | – | Counter electrode/encapsulation resin/aluminum foil | O | O | O | OO |
| Example 2 | CH₃NH₃PbI₂Br | Polyisobutylene | 7.2 | Not used | – | Counter electrode/encapsulation resin/aluminum foil | O | O | O | OO |
| Example 3 | CH₃NH₃PbI₂Cl | Polyisobutylene | 7.2 | Not used | – | Counter electrode/encapsulation resin/aluminum foil | O | O | O | OO |
| Example 4 | CH₃NH₃PbBr₃ | Polyisobutylene | 7.2 | Not used | – | Counter electrode/encapsulation resin/aluminum foil | O | O | O | OO |
| Example 5 | CH₃(NH₂)₂PbI₃ | Polyisobutylene | 7.2 | Not used | – | Counter electrode/encapsulation resin/aluminum foil | O | O | O | OO |
| Example 6 | CH₃NH₃PbI₃ | Silicone | 7.4 | Not used | – | Counter electrode/encapsulation resin/aluminum foil | O | O | O | OO |
| Example 7 | CH₃NH₃PbI₃ | Polyethylene | 8.6 | Not used | – | Counter electrode/encapsulation resin/aluminum foil | O | O | O | OO |
| Example 8 | CH₃NH₃PbI₃ | Polybutadiene | 8.4 | Not used | – | Counter electrode/encapsulation resin/aluminum foil | O | O | O | OO |
| Example 9 | CH₃NH₃PbI₃ | Ethylmethacrylate | 9.4 | Not used | – | Counter electrode/encapsulation resin/aluminum foil | O | △ | △ | OO |
| Example 10 | CH₃NH₃PbI₃ | PMMA | 9.6 | Not used | – | Counter electrode/encapsulation resin/aluminum foil | O | △ | △ | OO |
| Example 11 | CH₃NH₃PbI₃ | Polyisobutylene | 7.5 | ZnSnO(Si) | 100 | Counter electrode/inorganic layer/encapsulation resin/aluminum foil | O | O | O | OOO |
| Example 12 | CH₃NH₃PbI₃ | Polyisobutylene | 7.5 | SiO₂ | 100 | Counter electrode/inorganic layer/encapsulation resin/aluminum foil | O | O | O | OOO |
| Example 13 | CH₃NH₃PbI₃ | Polyisobutylene | 7.5 | SnO₂ | 100 | Counter electrode/inorganic layer/encapsulation resin/aluminum foil | O | O | O | OOO |
| Example 14 | CH₃NH₃PbI₃ | Isobornyl methacrylate | 9.2 | ZnSnO(Si) | – | Counter electrode/encapsulation resin/inorganic layer | O | O | O | OO |
| Example 15 | CH₃NH₃PbI₃ | Polyisobutylene | 7.2 | Not used | – | Counter electrode/encapsulation resin | O | O | O | O |
| Example 16 | CH₃NH₃PbI₃ | Norbornene | 8.9 | Not used | – | Counter electrode/encapsulation resin | O | O | O | O |
| Example 17 | CH₃NH₃PbI₃ | Isobornyl methacrylate | 9.2 | Not used | – | Counter electrode/encapsulation resin | O | O | O | O |
| Comparative Example 1 | CH₃NH₃PbI₃ | PVA | 14.1 | Not used | – | Counter electrode/encapsulation resin/aluminum foil | × | – | – | – |
| Comparative Example 2 | CH₃NH₃PbI₃ | Epoxy | 10.8 | Not used | – | Counter electrode/encapsulation resin/aluminum foil | × | – | – | – |
| Comparative Example 3 | CH₃NH₃PbI₃ | Phenolic resin | 13.5 | Not used | – | Counter electrode/encapsulation resin/aluminum foil | × | – | – | – |
| Comparative Example 4 | CH₃NH₃PbI₃ | Not used | Not used | Not used | – | Counter electrode | – | – | – | × |

1) 100°C 24h
2) 120°C 72h

## INDUSTRIAL APPLICABILITY

The present invention can provide a solar cell that is excellent in photoelectric conversion efficiency, suffers little degradation during encapsulation (initial degradation), and has high-temperature durability.

## REFERENCE SIGNS LIST

1:    solar cell
2:    electrode
3:    counter electrode (patterned electrode)
4:    photoelectric conversion layer
5:    encapsulation resin layer
6:    substrate

## Claims

**1.** A solar cell (1) comprising:

a laminate having an electrode (2), a counter electrode (3) having a patterned structure, and a photoelectric conversion layer (4) disposed between the electrode (2) and the counter electrode (3);
an encapsulation resin layer (5) covering the counter electrode (3) to encapsulate the laminate and directly contacting the photoelectric conversion layer (4) with the encapsulation resin layer (5) in the places where the counter electrode (3) is patterned,
the photoelectric conversion layer including an organic-inorganic perovskite compound represented by the formula: $R\text{-}M\text{-}X_3$, R representing an organic molecule, M representing a metal atom, X representing a halogen atom or a chalcogen atom,
the encapsulation resin layer (5) consisting of a resin having a solubility parameter, i.e., a SP value, of 10 or less,
the solar cell further including an inorganic layer on the encapsulation resin layer (5), and
the inorganic layer containing an oxide, nitride, or oxynitride of Si, Al, Zn, or Sn.

## Patentansprüche

**1.** Solarzelle (1), die umfasst:

ein Laminat mit einer Elektrode (2), einer Gegenelektrode (3) mit einer gemusterten Struktur und einer photoelektrischen Umwandlungsschicht (4), die zwischen der Elektrode (2) und der Gegenelektrode (3) angeordnet ist;
eine Einbettungsharzschicht (5), die die Gegenelektrode (3) bedeckt, um das Laminat einzubetten, und die mit der photoelektrischen Umwandlungsschicht (4) in direktem Kontakt ist, wobei die Einbettungsharzschicht (5) an Stellen vorliegt, an denen die Gegenelektrode (3) gemustert ist,
wobei die photoelektrische Umwandlungsschicht eine organischanorganische Perowskitverbindung aufweist, die durch die Formel: $R\text{-}M\text{-}X_3$ dargestellt ist, wobei R ein organisches Molekül darstellt, M ein Metallatom darstellt, X ein Halogenatom oder ein Chalkogenatom darstellt,
wobei die Einbettungsharzschicht (5) aus einem Harz mit einem Löslichkeitsparameter, also einem SP-Wert von 10 oder weniger besteht,
wobei die Solarzelle ferner eine anorganische Schicht auf der Einbettungsharzschicht (5) aufweist, und
wobei die anorganische Schicht ein Oxid, Nitrid oder Oxynitrid von Si, Al, Zn oder Sn enthält.

## Revendications

**1.** Cellule solaire (1) comprenant :

un stratifié ayant une électrode (2), une contre-électrode (3) ayant une structure dotée d'un motif, et une couche de conversion photoélectrique (4) disposée entre l'électrode (2) et la contre-électrode (3) ;
une couche de résine d'encapsulation (5) recouvrant la contre-électrode (3) pour encapsuler le stratifié et venir directement au contact de la couche de conversion photoélectrique (4) avec la couche de résine d'encapsulation (5) aux endroits où la contre-électrode (3) est dotée d'un motif,
la couche de conversion photoélectrique contenant un composé perovskite organique-inorganique représenté par la formule : $R\text{-}M\text{-}X_3$, R représentant une molécule organique, M représentant un atome de métal, X représentant un atome d'halogène ou un atome de chalcogène,
la couche de résine d'encapsulation (5) consistant en une résine ayant un paramètre de solubilité, c'est-à-dire une valeur SP, de 10 ou moins,
la cellule solaire contenant en outre une couche inorganique sur la couche de résine d'encapsulation (5), et

la couche inorganique contenant un oxyde, nitrure ou oxynitrure de Si, Al, Zn ou Sn.

FIG.1

● : M

◉ : R

◍ : X

FIG.2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006344794 A
- WO 2013171520 A1
- WO 2014042449 A2
- EP 2498330 A1
- WO 2011062932 A1

**Non-patent literature cited in the description**

- **REESE et al.** *Adv.Funct.Mater.,* 2010, vol. 20, 3476-3483
- *Proc.of SPIE,* vol. 7416, 74160K-1
- **R.F. FEDORS.** *Polym. Eng. Sci.,* 1974, vol. 14 (2), 147-154
- **J. BRANDRUP et al.** *Polymer Handbook, Fourth Edition,* vol. 2